(19) Europäisches Patentamt
European Patent Office
Office européen des brevets

(11) EP 0 606 745 B1

(12) EUROPEAN PATENT SPECIFICATION

(45) Date of publication and mention of the grant of the patent:
**16.09.1998 Bulletin 1998/38**

(51) Int Cl.6: **C23C 14/35**, H01L 21/768

(21) Application number: **93310163.6**

(22) Date of filing: **16.12.1993**

# (54) Collimated magnetron sputter-deposition apparatus

Magnetronzerstäubungsgerät mit Kollimator für die Beschichtung eines Substrats

Appareil de pulvérisation cathodique à magnetron ayant un collimateur

(84) Designated Contracting States:
**CH DE FR GB LI NL**

(30) Priority: **16.12.1992 US 992285**

(43) Date of publication of application:
**20.07.1994 Bulletin 1994/29**

(73) Proprietor: **VARIAN ASSOCIATES, INC.**
**Palo Alto, California 94304 (US)**

(72) Inventors:
- **Actor, Geri M.**
  **Monte Sereno, CA 95030 (US)**
- **Hoffman, Vance E., Jr.**
  **Los Altos, CA 94022 (US)**
- **Cochran, Ronald R.**
  **Mountain View, CA 94043 (US)**

(74) Representative: **Cline, Roger Ledlie**
**EDWARD EVANS & CO.**
**Chancery House**
**53-64 Chancery Lane**
**London WC2A 1SD (GB)**

(56) References cited:
**EP-A- 0 313 750** **EP-A- 0 440 377**
**EP-A- 0 509 305** **EP-A- 0 512 296**
**US-A- 5 223 108** **US-A- 5 252 194**

- **CRC Handbook of Chemistry and Physics, ed. R. C. Weast and M. J. Astle, West Palm Beach, US: CRC Press Inc., 1978, D-223 to D-225.**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 606 745 B1

## Description

This invention pertains generally to sputter coating and, more particularly, to an apparatus and a method for depositing a thin film coating and, more particularly, to an apparatus and a method for depositing a thin film coating on a workpiece by collimated sputtering.

Sputter coating is commonly employed in the formation of films on substrates in the manufacture of semiconductor devices. Planar magnetrons have long been used as sputtering devices to coat silicon wafers with various materials during the manufacture of integrated circuits. While aluminium has traditionally been the most common metallization material used in integrated circuits, other sputtered materials, such as titanium, titanium nitride, and titanium/tungsten alloy are now also commonly being used. Sputtering is also used during semiconductor manufacturing to deposit various non-metallic compounds either by direct sputtering or by reactive sputtering. Some of these non-metallic compounds, such as titanium nitride, are sufficiently conductive to be used in interconnect structures.

As integrated circuit densities have increased and device geometries have correspondingly shrunk, it has become more difficult to use sputter coating to form a uniform thin film, or step coating, which conforms to the shape of the surface of the workpiece or substrate where a step occurs, particularly at the upper or lower corner of an opening such as a hole or a via in the surface of the workpiece. It is also difficult to fill small openings (e.g., now commonly one micron, or less, in diameter or width) and to provide controlled film growth on the side and bottom walls of such openings. These difficulties arise because the sputtered atoms tend to leave the source in all directions, then collide with each other and scatter, arriving at the workpiece from a variety of angles. Particles (atoms) which arrive at angles much different than normal to the substrate surface tend to produce lateral growth on the surface. this lateral growth can result in overgrowth at the tops of the openings which can eventually close off via openings before they can be properly coated, resulting, for example, in an adequate electrical connection between integrated circuit layers.

One approach to overcoming the foregoing problem is to use a collimation filter to limit the angles with which sputtered atoms strike the workpiece. The theory of collimation is that if, on average, the angles of incidence of sputtered particles are close to normal, then more of the atoms will penetrate to the bottoms of via holes, so that a conformal film will be formed in the via and there will be little or no overgrowth at the top of the via. The collimating filter typically comprises a plurality of cells in an array which is interposed between a sputter source and a workpiece. To reach the substrate, atoms emitted from the sputter source must pass through the cells without striking the cell walls, i.e., the cell walls intercept sputtered particles travelling at angles which are not close to being normal to the substrate. This causes a substantial amount of sputtered material to deposit on the filter itself.

However, there have been several problems associated with prior art sputtering systems employing collimation filters. First, unless the sputter source is very highly uniform, there will be an uneven film distribution on the surface of the wafer. Most sputter sources, particularly those which are used with the large semiconductor wafers common in the industry today (e.g., wafers having an eight-inch diameter), do not have a sufficiently uniform emission distribution to work with a collimation filter. These sputter sources rely on the scattering and angularity of sputtered particles to compensate for the fact that atoms are not emitted at a uniform rate from all points on the sputter target. however, a collimating filter negates the compensating effects of angularity and scattering.

Thus, if a sputter source does not emit particles from its center, then an adequate layer of film will not be deposited at the center of the wafer.

Second, most sputter sources operate at pressures at which particle scattering is a significant effect over short distances. At the pressures commonly employed, the mean-free-path of sputtered atoms is relatively short. Accordingly, any directionality imparted to the particle flux by the collimation filter will be lost over a relatively short distance due to scattering. One attempted solution to this problem has been to place the collimation filter very close to the surface of the substrate to minimize scattering effects. However, this "solution" causes a shadowing effect such that the pattern of collimation filter cell walls is noticeably present on the surface of the wafer. Some prior art discloses means for moving either the filter or the wafer to avoid the shadowing effect. Movement of the wafer over a large area can also help overcome the aforementioned problem of non-uniformity. However, wafer movement is undesirable due to the added complexity it creates and the increased likelihood of contamination associated with moving parts within the sputter chamber.

Another problem with prior art sputtering sources using collimation to fill small diameter, high aspect ratio vias is that there has been no recognition of the need to optimize the aspect ratio of the collimation filter so that there is a desired balance between the deposition on the sidewall of the via and the bottom of the via. If the aspect ratio of the collimator cells is too high, there will be too little sidewall deposition. On the other hand, if the aspect ratio of the collimator cells is too low the sputtered atoms will behave much as if there is no filter with the same result, e.g., undesired film build-up and overhang at the corners of the via which blocks film from reaching the via bottom.

Yet another problem with prior art sputtering systems using collimation is that much of the sputtered material is deposited on the walls of the collimation filter rather than on the substrate. Not only does this reduce the deposition rate, thereby impairing wafer "throughput", but also has a tendency to increase the amount of particulate material in the sputter chamber. As a film of sputtered material is deposited on the call walls the material tends to "flake" off. Some of the large particles thus formed end up on the surface of the wafer, where they can destroy the integrated circuit chips being fabricated. Semiconductor manufacturers go to great lengths to minimize the presence of extraneous particles in the wafer processing environment. It should also be noted that moving the wafers or collimation filter, as described above, can exacerbate the problem of extraneous particle creation.

The apparatus of EP-A-0440377 deals with the above problems and provides a magnetron sputtering apparatus for depositing a film on a workpiece, comprising a vacuum chamber; workpiece holding means situated within said vacuum chamber for holding a workpiece to be sputter coated; sputtering means for emitting particles used to form a film on said workpiece into said vacuum chamber, said sputtering means generally opposing said workpiece to be coated, said sputtering means comprising a sputter target from which said sputtered particles are uniformly emitted and having an area larger than the workpiece to be coated, said area including the central portion of the sputter target; and collimator means interposed between said workpiece and said sputtering means for limiting the angles of the particles which pass through said collimator means. Aspect ratios in the range 1:1 to 3:1 are suggested.

The sputtering apparatus of the earlier PCT application WO-A-93/13542 describes a collimator having tapering passages and which may be formed of titanium.

Most known prior art collimating filters have been constructed out of stainless steel. When sputtering aluminium, which has heretofore been the most common metallization layer used in semiconductor manufacture, extraneous particle creation has not been unacceptably poor. However, when sputtering films of newer materials, such as titanium, titanium nitride, or titanium/tungsten alloy, particle creation becomes unacceptable when using a collimation filter made of stainless steel. It is noted that these newer materials are finding increasing use as device geometries shrink and, hence, the need for the benefits of collimation increases.

In the present invention the collimator means is made of a material consisting primarily of titanium and comprises a plurality of substantially identical individual collimator cells, said collimator cells having an aspect ratio in the range of 0.5:1 to 4:1.

An example of the invention will now be described with reference to the accompanying drawings in which:-

Fig. 1 is a diagrammatic cross-sectional view of sputtering apparatus;

Fig. 2 is a top plan view, on a reduced scale, of a particle collimating filter for use in the embodiment of Fig. 1;

Figs. 3a - 3b are fragmentary cross-sectional views illustrating some of the problems encountered in the formation of a step coating with conventional sputtering techniques.

Figs. 4a - 4d are graphical representations showing the relationship between pressure and the angular distribution of particles arriving at the surface of a workpiece with collimating filters of different aspect ratios.

Figs. 5a - 5c are isometric views of a portion of such a collimation filter at various stages of construction.

Figs. 6a - 6d are graphical representations showing the relationship between bottom wall deposition rate and aspect ratios of holes or vias and collimating filters.

Figs. 7a - 7b are fragmentary cross-sectional views of a workpiece, illustrating the formation of a step coating with the apparatus and method described.

In the embodiment of Fig. 1, the sputtering apparatus has a housing 16 in which a sputtering chamber 17 is formed. The housing includes a cylindrical side wall 18 with annular flanges 19, 21 toward the upper and lower ends thereof, and a bottom wall 22 which mates with flange 21. An O-ring 23 provides a seal between the two walls.

The central portion of bottom wall 22 is raised to form a table 24 for supporting a wafer W or other workpiece to be coated. The workpiece may be secured to the table by suitable means such as a peripheral clamping ring (not shown) or other suitable means. Means of retaining a wafer in position are well known to those skilled in the art and need not be described in further detail. The table includes conventional heating and cooling means (not shown) for controlling the temperature of the workpiece.

The housing and support table are fabricated of an electrically conductive material such as stainless steel and are connected electrically to ground. In accordance with the present invention, if flaking of deposited film from any of these surfaces is a problem, they can, alternatively, be made of a material which is more compatible with the film being deposited. However, thus far the inventors have not found film flaking from these components to be a significant problem.

A source 26 of atoms for coating the workpiece is mounted in the upper portion of housing 16. In the embodiment illustrated, the source is a planar magnetron source using a closed-loop rotating magnet, of the type described in detail in EP-A-0439360. The source described in that specification is commercially available from Varian Associates, Inc., of Palo Alto, California, under the trademark "Quantum". (It is noted that the source depicted in Fig. 1 may not exactly replicate the Quantum source which is more accurately portrayed in the aforementioned patent specification; however, any differences are not deemed pertinent to the present invention.) An important feature of this source is that it provides a substantially uniform emission of particles over an extended target area which is larger than the workpiece. This ensures that a uniform distribution of particles reaches the entire surface of the workpiece, including the peripheral areas. While this particular source is presently preferred, any other source which provides a similarly uniform particle distribution can be employed. In the source described there is an extended area of uniform erosion including the centre of the sputter target.

Source 26 includes a planar, circular target 27 of a material to be deposited. The collimation filter of the present invention works particularly well with targets made of titanium and titanium tungsten alloy. In addition, it is particularly useful in connection with the reactive sputtering of films of titanium nitride, which is performed by sputtering from a titanium target in the presence of a partial pressure of nitrogen. Methods of reactive sputtering of titanium nitride are known to those skilled in the art and need not be described in further detail.

Sputter target 27 is disposed in parallel facing relationship to the workpiece and is of greater lateral extent than the workpiece. In one embodiment for use with wafers having a diameter of 20.3cm, sputter target 27 has a diameter of 28.6cm.

The target is mounted on the under side of an electrically conductive cathode plate 28 which has a cylindrical side wall 29 with an annular flange 31 at the upper end thereof. The cathode plate is supported by a cylindrical mounting bracket 32 with annular flanges 33, 34 at the upper and lower ends thereof. Flange 33 projects outwardly from side wall 29 and is positioned above the inwardly projecting housing flange 19. A spacer ring 36 is positioned between these flanges to permit adjustment of the spacing between the target and the workpiece, which is typically on the order of 2 - 8cms.

Flange 31 on the cathode plate projects outwardly from side wall 29 and is positioned above the inwardly projecting flange 34 at the lower end of mounting bracket 32. A ring 37 of electrically insulative material is positioned between the flanges to insulate the cathode from the housing, and O-rings 38, 39 provide seals between the flanges and the insulator.

A cover 41 fabricated of an insulative material, such as fiberglass, is positioned within mounting bracket 32 and secured to flange 31 of the cathode plate by screws 42 to form a chamber 43 for the rotating magnet assembly of the magnetron. An electrical lead 44 is connected to one of the mounting screws 42 and to a suitable source (not shown) for applying a high negative potential to the cathode.

The magnet assembly includes a housing 46 in which a closed-loop array of magnets 47 is mounted. The structure of these magnets and the manner in which they provide substantially uniform erosion over substantially the entire area of the target are disclosed in detail in the aforementioned EP-A-0439360.

Magnet housing 46 is mounted on a shaft 48 which passes though a seal assembly 49 in cover 41 and is connected to a motor 51 by coupling 52 for rotation about an axis 53. Motor 51 is mounted on a slider assembly 54 which is driven by a linear motor 56 for movement along axis 53, and the slider assembly is mounted on a bracket 57 affixed to housing 16. The slider assembly permits the spacing between the magnet array and the target to be adjusted to control the magnetic field beneath the target. As discussed more fully in the aforementioned EP-A-0439360, with a 28.5cms target, the rotating magnet array provides substantially uniform erosion throughout a circular region having a diameter of approximately 25cms centered about the axis of rotation, which is sufficient for coating a 20cm wafer.

Housing 16 includes a port 58 to which a vacuum pump (not shown) is connected for evacuating chamber 17, and a gas inlet 59 through which an inert gas such as Argon is introduced to support the magnetron discharge. As discussed more fully hereinafter, the pressure within chamber 17 is maintained at a pressure which is sufficiently low to prevent the sputtered atoms from colliding with each other and scattering after they have passed through the collimation filter. It is contemplated that the present invention will be used with pressures on the order of .01 - 2.0Pa; however, it has been determined that many of the advantages of the invention can be obtained using higher pressures.

Housing 16 also includes a port 61 through which wafers or other workpieces are transported into and out of chamber 17. This port is provided with a suitable closure such as a gate valve (not shown).

A port 62 is provided in cover 41 for introducing a coolant such as water into chamber 43 to cool the target and the magnet assembly.

A particle collimating filter 63 is positioned between the target and the workpiece to limit the angles at which the atoms from the source can arrive at the surface of the workpiece. This filter, together with the extended source and the absence of scattering, is important in preventing lateral film growth and in forming a step coating with controlled growth on the bottom and side walls of an opening such as a hole or via.

The collimating filter has a plurality of cells 64 with apertures through which the particles pass in line-of-sight fashion. The cells are aligned with their axes parallel to axis 53 and perpendicular to the surfaces of target 27 and workpiece W. Each cell has an acceptance angle $\theta_{ACC}$ which is defined as

$$\theta_{ACC} = \arctan (d/1),$$

where d is the diameter of the aperture and 1 is the length of the aperture, or the height of the cell. The acceptance angle is thus the maximum angle from the perpendicular (i.e., normal to the substrate) at which particles can pass through the filter in a straight path without striking the wall of a cell. The aspect ratio of the cells, i. e., the ratio of the cell height to the diameter, is referred to as the aspect ratio of the filter.

In the embodiment illustrated, the cells and their apertures are hexagonal in cross-section. This shape is preferred to a circular shape or a square shape because of the unusable areas between the walls of adjacent circular cells and the substantial difference in the distances between the opposing sides and the opposing corners of square cells. In this disclosure, the diameter utilized in defining the acceptance angle and the aspect ratio of the hexagonal cells is the mean diameter of the cells, although either the flat-to-flat diameter or the apex-to-apex diameter could be utilized for this purpose, if desired.

In the embodiment of Fig. 1, collimating filter 63 is positioned approximately midway between the target and the workpiece and is attached to mounting bracket 32 by brackets 66 and screws 67. In other embodiments, collimating filter 63 may be placed relatively closer to the wafer to minimize scattering effects, so long as it is not placed so close as to cause shadowing as described above. Depending on the application, collimator 63 may be placed in the range of 1 - 5cms from the wafer and between 2 to 12cms from the sputter target.

According to the present invention, collimating filter 63 has an aspect ratio in the range of 0.5:1 to 4:1, preferably between 1:1 to 3:1, with a mean cell diameter on the order of 9 - 15cms for a 28cm target and 20cm wafer separated by a distance on the order of 2 - 15cms.

Collimating filter 63 is constructed of titanium. The apparatus according to the present invention is therefore suitable when sputtering titanium, either non-reactively to produce a titanium film or reactively to produce a titanium nitride film, or when sputtering a titanium/tungsten alloy non-reactively to form a titanium/tungsten film. The collimating filter may be fabricated starting with ribbons or elongate sheets of titanium having the desired width "W" (equal to the desired cell length). An example of a piece of titanium ribbon 560 is shown in Fig. 5a. The titanium ribbon used in connection with the present invention may have a thickness of approximately 0.4mm. After being cut to length, ribbons 560 are then stamped into corrugated pieces having half hexagons with alternating orientations. Two such pieces, 565 and 567, are shown in Fig. 5b. The stamped ribbons are then successively joined by spot welding to form rows of cells having the desired hexagonal cross-sectional shape. Fig. 5c shows two such ribbons that have been joined together to form a portion of a collimating filter 563.

Fig. 3a illustrates some of the problems encountered in forming a step coating by sputtering prior to the invention. In this example, a hole 71 having a diameter of one micron is formed in a one micron layer 72 of dielectric material on a silicon substrate 73. Hole 71, therefore, has an aspect ratio of 1:1. A metallized contact is to be formed over a doped region 74 in the substrate at the bottom of the hole. The metallization material is sputtered from a target 75 above the wafer. It is assumed that each point on the target uniformly emits particles with a cosine distribution, and after collision and scattering, the particles arrive at the target at angles (θ) ranging from 0 to 90 degrees to the normal. However, as described above, known prior art sputtering sources do not provide the assumed level of uniformity.

In this example, particles arriving at angles greater than 45 degrees cannot impinge upon the bottom wall of the hole. When such particles impinge on the upper surface of layer 72 they tend to promote lateral growth on the surface of the wafer. As a result, a relatively thick film 76 is built up on the surface of the wafer, with relatively thin, nonuniform coatings 77, 78 on the side and bottom walls of the hole. In addition, the lateral growth of the surface film produces an overgrowth 79 at the top of the hole, which eventually can close off the hole completely and prevent particles from entering it. When closed off in this manner, the coating on the side walls and the bottom wall is subject to voiding, as illustrated by broken lines in the drawing, and there will be areas where no coating is formed. Thus, good electrical contact to region 74 will not be made.

Fig. 2b illustrates a problem of asymmetrical coating which can occur in openings near the edge of a wafer with conventional sputtering techniques utilizing a 28cm planar source, a surface deposition rate of 1 micron per minute, a target-to-wafer spacing of 7cm, a sputtering pressure on the order of 0.4 - 1Pa, and a wafer table temperature of 250°C. In this figure, two holes 81, 82 are shown. Hole 81 is near the edge. Near the center of the wafer, the particle distribution is relatively uniform, and a relatively symmetrical coating is formed in hole 81. Toward the edge of the wafer, however, the distribution of particles is not as uniform, and the inwardly facing side wall 82a of hole 82 receives more particles than the outwardly facing wall 82b. This results in an asymmetrical coating of the side walls as well as the bottom wall.

With the collimation filter, the extended source, proper selection of pressure, and proper selection of the aspect ratio of the filter, it is possible to form good step coatings in which the growth of film on the side and bottom walls of an opening is controlled.

Figs. 4a - 4d illustrate the effect of pressure on the angular distribution of sputtered particles arriving at the surface of a workpiece without a collimation filter and for three filters of different aspect ratios. In the figures, the angle of arrival (θ), relative to the perpendicular, is plotted along the x- axis and the number of particles arriving at the surface is plotted along the y-axis. The date for these figures was obtained by computer simulation assuming uniform erosion from a 28cm planar source, with a 150mm substrate and a 9cm source-to-substrate spacing in the Argon sputtering of aluminium. (The validity of the data obtained by computer simulation has since been confirmed in actual experiments). The particle count is arbitrary and was selected to be large enough to give meaningful distribution date. The same overall particle count was used in each of the simulations so that the relative reduction in particles reaching the substrate in successive figures reflects the higher percentage of material that is intercepted by the filter and, thus, not deposited.

In each of Figs. 4a - 4d, curves representing the distributions for operating pressures of .00006Pa, .003Pa, .06Pa, and .13Pa are shown, and in Figs. 4b-4d a curve for a pressure of 0.26Pa is also shown.

Fig. 4a shows the distribution with no filter, and Figs. 4b - 4d show the distributions with filters having aspect ratios of 1:1, 1.5:1 and 2:1 respectively.

Without the filter, the distribution is fairly symmetrical at the lower pressures for angles up to about 60 degrees. At the higher pressures, the distribution is less symmetrical, and greater relative numbers of the particles arrive at angles greater than 60 degrees.

With each of the filters, the distribution is fairly symmetrical at the lower pressures up to the acceptance angle of the filter. At the higher pressures, the distribution is less symmetrical, and greater relative numbers of the particles arrive at angles greater than the acceptance angle. The increase in the number of particles outside the acceptance angle at the higher pressures is due to scattering of the particles at the higher pressures after they transit the collimation filter. These curves illustrate the importance of lower pressures to avoid scattering so that as many atoms as possible reach the wafer surface at angles less than or equal to the acceptance angle of the collimation filter.

Figs. 6a - 6d illustrate the relationship between the initial deposition rate on the bottom wall and the aspect ratios or holes or vias and collimating filters. In these figures, distance from the center of the hole or via expressed as a fraction of the radius of the hole or via is plotted along the x-axis, and the rate of deposition on the surface of the wafer is plotted along the y-axis. The target is assumed to be sufficiently large that the location of the opening on the wafer is unimportant. Curves are included for holes having aspect ratios ranging from 0.25:1 to 2:1. Fig. 6a shows the relationship without a collimating filter, and Figs. 6b - 6d show the relationship for filters having aspect ratios of 1:1, 2:1 and 4:1, respectively.

With no filter and a hole having an aspect ratio of 1:1, the coating is full thickness toward the center of the opening but only about half thickness near the wall. With a filter having an aspect ratio of 1:1, the coating on the bottom wall is substantially more uniform, ranging from a normalized value of about .70 toward the center to about .40 near the wall. The bottom coating is even flatter with filters having aspect ratios of 2:1 and 4:1, but it is also substantially thinner.

With no filter and a hole having an aspect ratio of 2:1, the bottom coating varies in thickness from a normalized value of about .60 toward the center to about .30 near the wall. With a filter having an aspect ratio of 1:1, the coating is more uniform, ranging from a normalized thickness of about .26 near the center to about .20 toward the wall. With a 2:1 filter, the coating is even more uniform, with a normalized thickness of about .13 from the center to the wall.

It can be seen that there is a trade-off between uniformity across the bottom of a via and deposition rate at the bottom. Increasing the aspect ratio of the filter tends to improve uniformity at the expense of deposition rate.

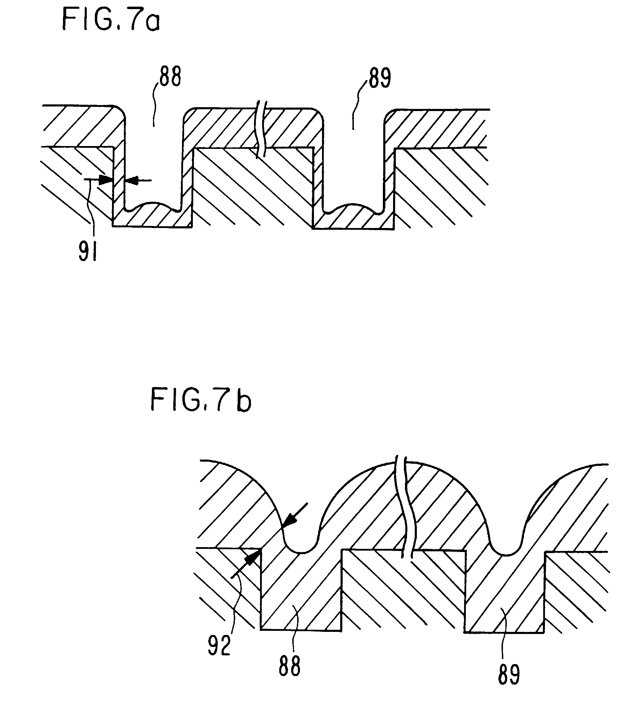

Figs. 7a - 7b illustrate the formation of a step coating. Each of these figures shows a pair of holes 88, 89 having aspect ratios of 1:1, with hole 88 being located near the center of a wafer and hole 89 being toward the edge. Sputtering is performed at a pressure of 0.6Pa and a wafer table temperature of 250°C, with a 28cm planar source, a 7cm target to wafer spacing, a collimation filter having an aspect ratio of 1:1, and a surface deposition rate of 1 micron per minute.

Fig. 7a shows a half thickness coating of 0.5 micron on the wafer surface, and Fig. 7b shows a full thickness coating of 1 micron on the surface. The figures illustrate how the coating builds up evenly on the side walls of the openings without the overcoatng and asymmetry of the prior art techniques illustrated in Figs. 3a -3b. Another advantage which is apparent from these figures is that the thinnest part of the step coating is no longer at the lower corner of the hole as it is in the coatings of Figs, 3a - 3b. Film integrity at the corner of a via is especially important in obtaining a coating within the via having good, reliable electrical properties. With the half thickness coating, the thinnest point occurs along the side wall, as indicated by the arrows 91, and with the full thickness coating, it occurs at the upper corner of the hole, as indicated by the arrows 92. From these figures, it can also be noted that the aspect ratio of the unfilled volume increases as the coating builds up in the holes.

As described above, the titanium collimation filter of the present invention may be used in connection with sputtering from targets comprising titanium. The number of extraneous particles created when using a titanium collimation filter are greatly reduced from those of the prior art. Indeed, particle counts are such that sputtering of titanium compounds using a titanium collimation filter can be as clean or cleaner than the deposition of comparable materials by chemical vapor deposition (CVD).

Heretofore, attempts at collimated sputtering of titanium, titanium nitride, and titanium/tungsten alloy have not been practical due to creation of an unacceptable number of extraneous particles as the deposited film grew in thickness on the collimator cells. In one experiment, for example, particles of titanium nitride began flaking off of a stainless steel collimation filter after only running 400 wafers. Under the same conditions, but substituting a titanium collimation filter, no significant flaking of titanium nitride occurred until after approximately 3500 wafers had been processed, and it is believed that flaking only began at this point due to the presence of other stainless steel components in the sputter chamber, i.e., there was no apparent flaking from the collimator itself. This experiment represents more than seven-fold improvement and makes the collimated sputtering of titanium nitride practical. In another experiment 5500 wafers were processed before flaking occurred. In this experiment, a mounting ring on the collimator, that previously had been constructed of stainless steel, was also made of titanium, confirming the fact that other components in the processing chamber can contribute to extraneous particle creation.

It is noted that the useful life of a collimator used in connection with a sputtering source is limited. As sputtering is performed, film is deposited on and builds up on the surfaces of the collimator, including the collimator cells. As the thickness of the coating on the cells increases, the deposition rate and properties of the sputtered film changes. Eventually, the collimator must be replaced. It has been found a collimator as described, which is matched in materials properties with the film being deposited, is usable over a normal life without any flaking.

It may be desirable to fabricate other components within sputtering chamber from a material that is similarly compatible with the film to be deposited. The extent of the benefit of using a compatible material to fabricate another component will depend on the amount of film which is deposited on the component as the sputtering system is used, since flaking occurs as film thickness increases. A collimation filter, or other component, which is placed directly between the sputter source and the workpiece, will experience rapid film build up and, therefore, will begin flaking relatively quickly if there is a materials incompatibility problem. On the other hand, a cathode shield will experience little or no film deposition and, therefore, need not be made of a compatible material if doing so has any other disadvantages, such as higher manufacturing costs.

It is believed that the major factor accounting for the very high quality of sputtering attainable when using a titanium collimator for aforementioned films is the fact that there is no mismatch between the thermal coefficient of expansion of the sputtered material and the material from which the collimation filter is made. This matching of the thermal expansion characteristics obviates one of the primary causes of extraneous particle formation, i.e., flaking or spalling of the film deposited on the collimation filter as the filter and films undergo thermal cycling.

The thermal coefficient of expansion (TCE) of both titanium and titanium nitride is $10.8 \times 10^{-6}$/K ($6.0 \times 10^{-6}$/°F). With titanium nitride a very low mismatch is essential due to the brittleness and low ductility of the film. Other films that are more ductile, or which have better adhesion characteristics, can tolerate a greater mismatch. For example, titanium tungsten alloy has a TCE of $5.4 \times 10^{-6}$/K ($3.0 \times 10^{-6}$/°F), yet adheres well to a titanium collimator. Likewise, aluminium, with a TCE of 23.4 $\times 10^{-6}$/K ($13 \times 10^{-6}$/°F) adheres well to a stainless steel collimator (TCE of $17.8 \times 10^{-6}$/K ($9.9 \times 10^{-6}$/°F).

Titanium has one additional property which makes it highly suitable for the present application: it tends to be an adsorber of gas. Many materials, including many metals, will "outgas" in a vacuum environment thereby introducing potentially contaminating substances into the process chamber. While such outgassing can be controlled by first "baking-out" the part to accelerate the outgassing, frequently it is not possible to bake out a part fully in a reasonable time-period, so that it remains a potential source of contamination. Moreover, even if baked out, the part may be recontaminated if it is subsequently exposed to the ambient atmosphere. Although load-locks are commonly used in sputtering equipment, the process chambers may be, nonetheless, frequently exposed to the atmosphere. This is not a problem with titanium, insofar as it tends not to outgas.

**Claims**

1. A magnetron sputtering apparatus for depositing a film on a workpiece, comprising:

   a vacuum chamber;
   workpiece holding means situated within said vacuum chamber for holding a workpiece to be sputter coated;
   sputtering means for emitting particles used to form a film on said workpiece into said vacuum chamber, said sputtering means generally opposing said workpiece to be coated, said sputtering means comprising a sputter target from which said sputtered particles are uniformly emitted and having an area larger than the workpiece to be coated, said area including the central portion of the sputter target;
   and collimator means interposed between said workpiece and said sputtering means for limiting the angles of the particles which pass through said collimator means;
   said collimator means made of a material consisting primarily of titanium comprising a plurality of substantially identical individual collimator cells, said collimator cells having an aspect ratio in the range of 0.5:1 to 4:1.

2. Apparatus as claimed in Claim 1 wherein said collimator means comprises a plurality of individual collimator cells constructed from stamped pieces of titanium ribbon.

3. Apparatus as claimed in claim 1 or claim 2 wherein other components within said sputtering chamber are made of the same material as the collimator means.

## Patentansprüche

1. Magnetronsputtervorrichtung zum Abscheiden einer Schicht auf einem Werkstück, mit: einer Vakuumkammer;

   Werkstückhaltemitteln, welche innerhalb der Vakuumkammer angeordnet sind, zum Halten eines Werkstückes, welches sputterbeschichtet werden soll;
   Sputtermitteln zum Emitieren von Partikeln, welche verwendet werden, um eine Schicht auf dem Werkstück in der Vakuumkammer zu bilden, wobei die Sputtermittel dem zu beschichtenden Werkstück im wesentlichen gegenüberliegen, wobei die Sputtermittel ein Sputtertarget enthalten, von welchem die gesputterten Partikel gleichförmig emitiert werden, und eine Fläche aufweisen, welche größer ist, als das zu beschichtende Werkstück, wobei die Fläche den zentralen Abschnitt des Sputtertargets einschließt;
   und Kollimatormitteln, die zwischen dem Werkstück und den Sputtermitteln angeordnet sind, um die Winkel der Partikel, welche durch die Kollimatormittel hindurchtreten zu begrenzen; wobei die Kollimatormittel aus einem Material hergestellt sind, welches in erster Linie aus Titan besteht, mit einer Vielzahl von im wesentlichen identischen, individuellen Kollimatorzellen, wobei die Kollimatorzellen ein Längenverhältnis im Bereich von 0.5:1 bis 4:1 aufweisen.

2. Vorrichtung nach Anspruch 1, wobei die Kollimatormittel eine Vielzahl von individuellen Kollimatorzellen aufweisen, die aus gestanzten Titanbandstükken aufgebaut sind.

3. Vorrichtung nach einem der Ansprüche 1 oder 2, wobei andere Komponenten innerhalbder Sputterkammer aus dem gleichen Material hergestellt sind, wie die Kollimatormittel.

## Revendications

1. Appareil de métallisation par pulvérisation cathodique comprenant un magnétron, pour déposer un film sur une pièce à usiner, comprenant:

   une chambre à vide;
   un moyen de maintien de la pièce à usiner situé à l'intérieur de ladite chambre à vide pour maintenir une pièce à usiner qui doit être munie d'un dépôt par pulvérisation cathodique;
   un moyen de pulvérisation cathodique pour émettre des particules utilisées pour former un film sur ladite pièce à usiner dans ladite chambre à vide, ledit moyen de pulvérisation cathodique étant généralement opposé à ladite pièce à usiner qui doit être munie d'un dépôt, ledit moyen de pulvérisation cathodique comprenant une cible de pulvérisation à partir de laquelle lesdites particules pulvérisées sont émises de manière uniforme et dont l'aire de surface est supérieure à la pièce à usiner qui doit être munie d'un dépôt, ladite aire de surface englobant la portion centrale de la cible de pulvérisation;
   et un moyen de collimateur intercalé entre ladite pièce à usiner et ledit moyen de pulvérisation cathodique pour limiter les angles formés par les particules qui passent à travers ledit moyen de collimateur;
   ledit moyen de collimateur étant réalisé en une matière constituée principalement de titane, comprenant plusieurs cellules individuelles de collimateur essentiellement identiques, lesdites cellules de collimateur possédant un rapport nominal d'aspect dans le domaine de 0,5: 1 à 4:1.

2. Appareil selon la revendication 1, dans lequel ledit moyen de collimateur comprend plusieurs cellules individuelles de collimateur construites à partir de morceaux emboutis d'un ruban en titane.

3. Appareil selon la revendication 1 ou 2, dans lequel les autres composants à l'intérieur de ladite chambre de pulvérisation cathodique sont réalisés à partir de la même matière que celle du moyen de collimateur.

FIG.1

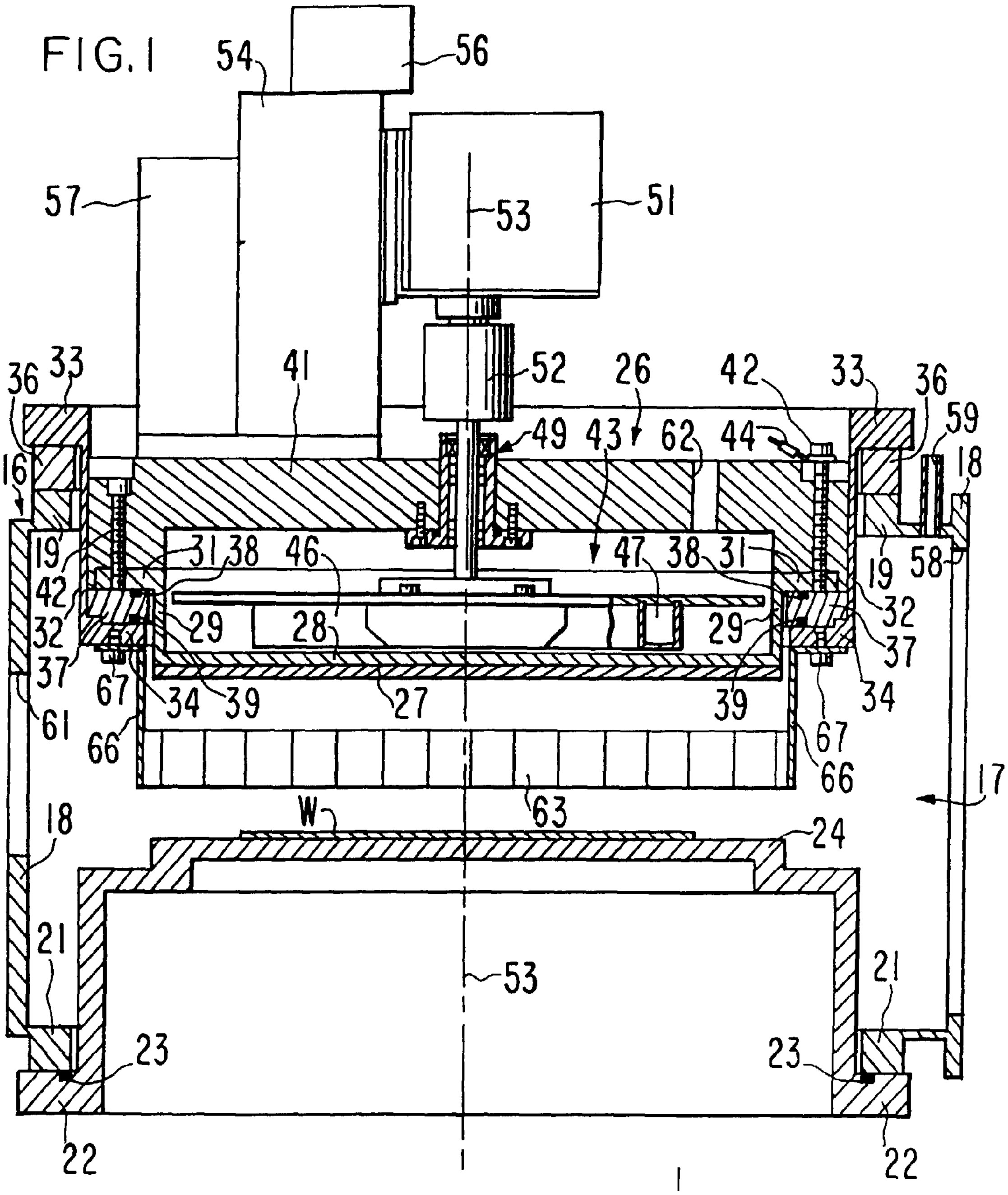
54
56
57
53
51
41
52
26
42
33
36
49
43
62
44
59
18
16
19
31
38
46
47
32
29
28
37
67
34
39
27
61
66
17
63
W
24
21
23
22

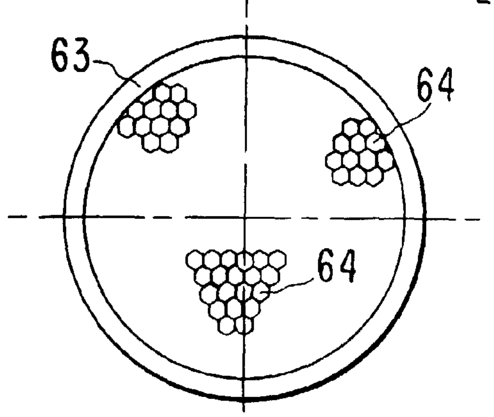
63
64
64

FIG.2

FIG.3a

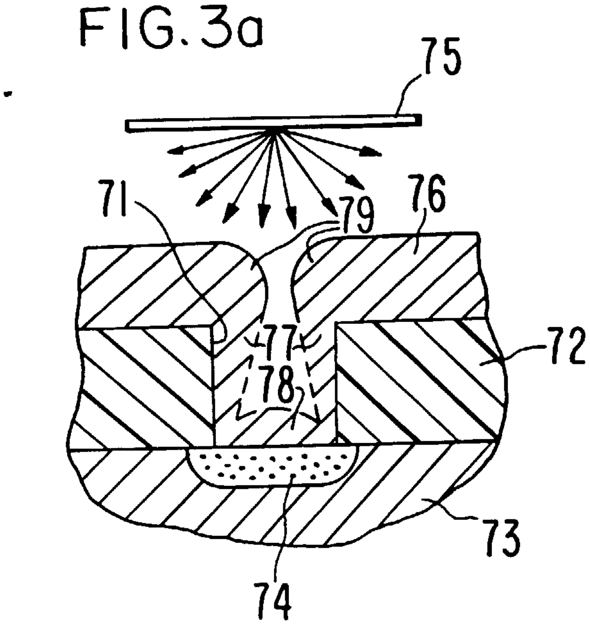


FIG.3b

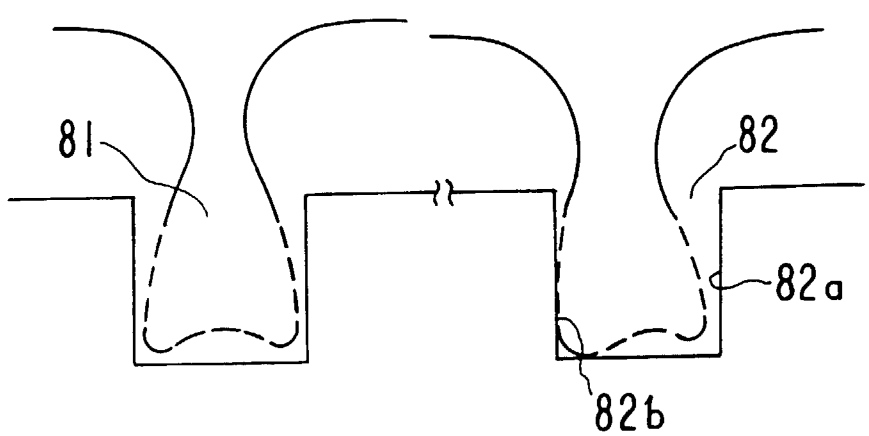

FIG.4a

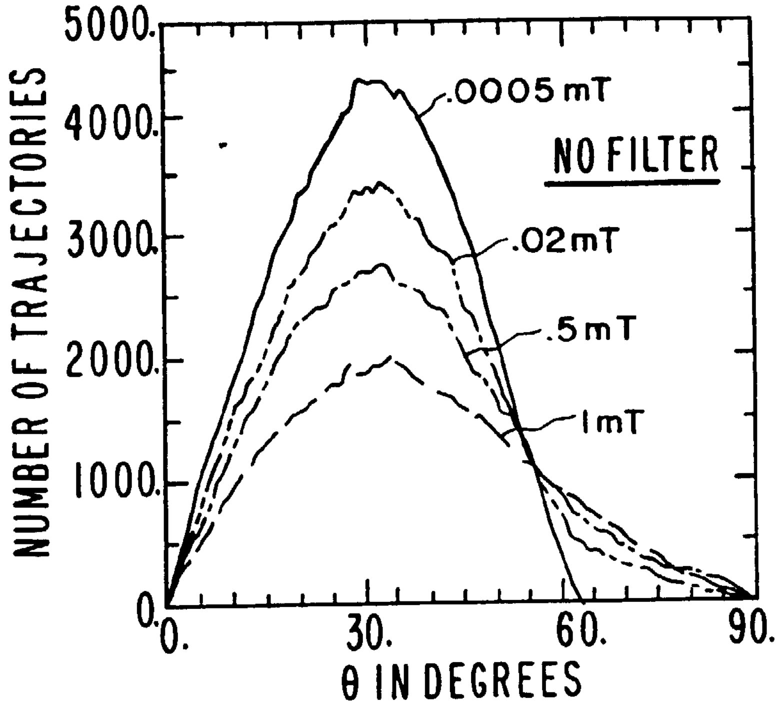
5000.
4000.
3000.
2000.
1000.
0.
NUMBER OF TRAJECTORIES
.0005 mT
NO FILTER
.02mT
.5mT
1mT
0.
30.
60.
90.
θ IN DEGREES

FIG.4b

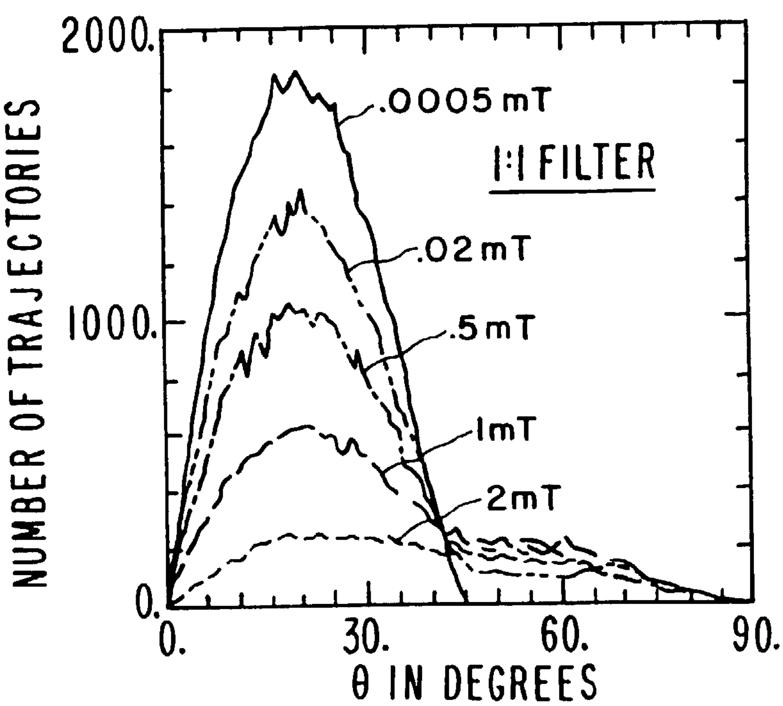
2000.
1000.
0.
NUMBER OF TRAJECTORIES
.0005 mT
1:1 FILTER
.02mT
.5mT
1mT
2mT
0.
30.
60.
90.
θ IN DEGREES

FIG. 4c

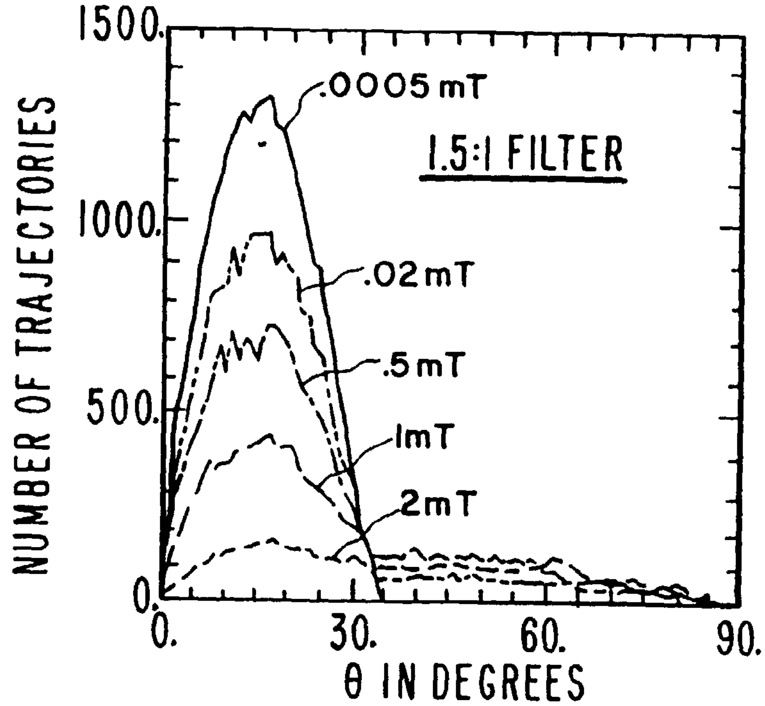
1500.
1000.
500.
0.
NUMBER OF TRAJECTORIES
.0005 mT
1.5:1 FILTER
.02 mT
.5 mT
1mT
2mT
0.
30.
60.
90.
θ IN DEGREES

FIG. 4d

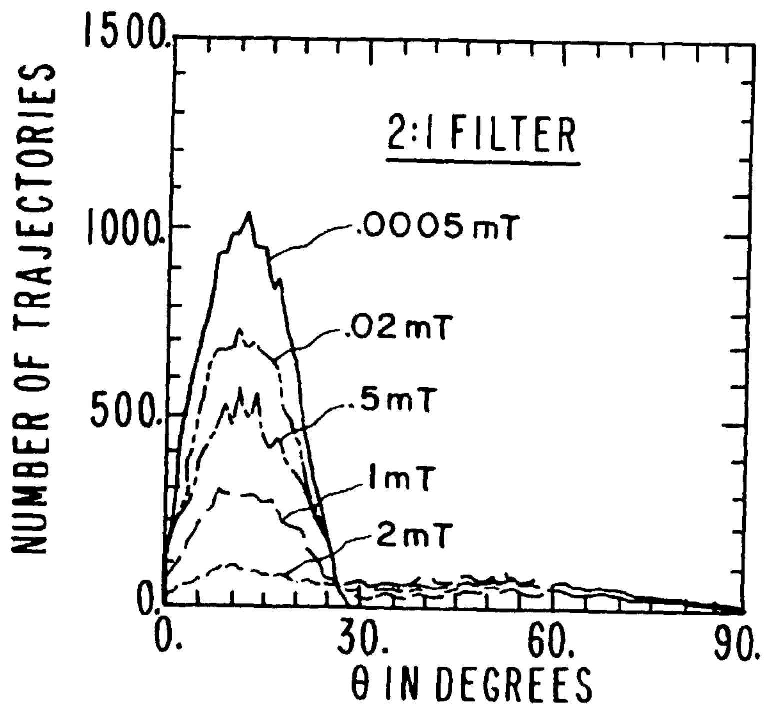
1500.
1000.
500.
0.
NUMBER OF TRAJECTORIES
2:1 FILTER
.0005 mT
.02 mT
.5 mT
1 mT
2 mT
0.
30.
60.
90.
θ IN DEGREES

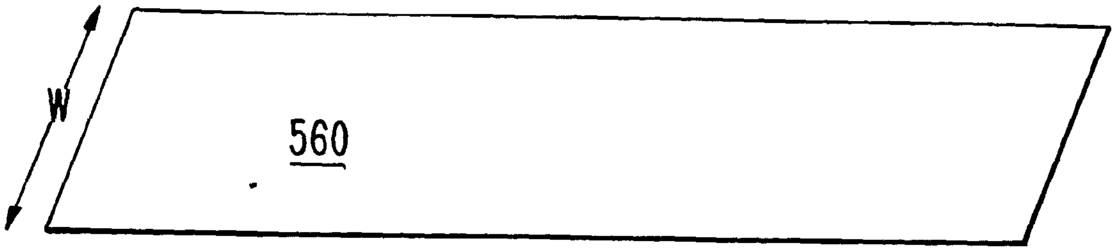


FIG. 5a

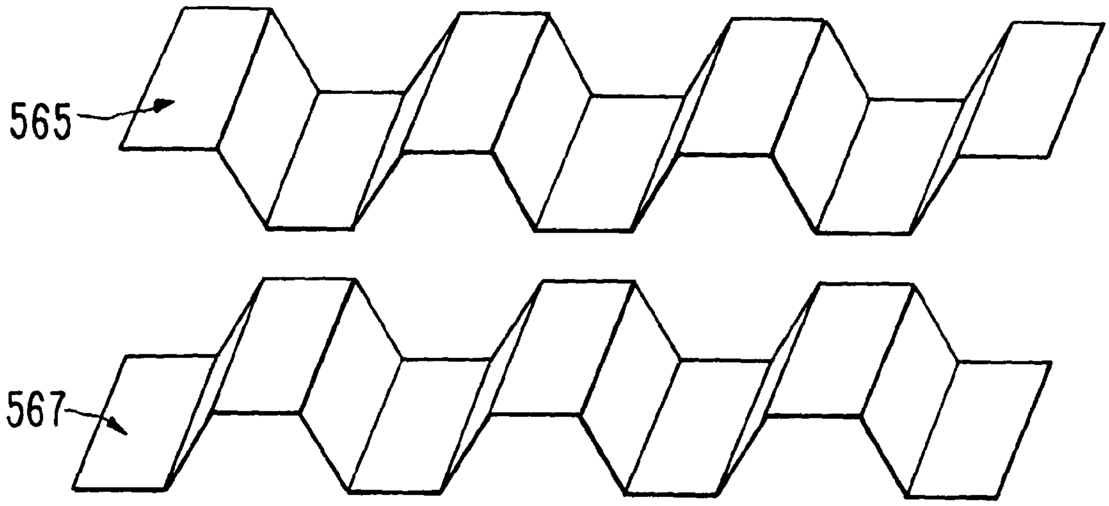


FIG. 5b

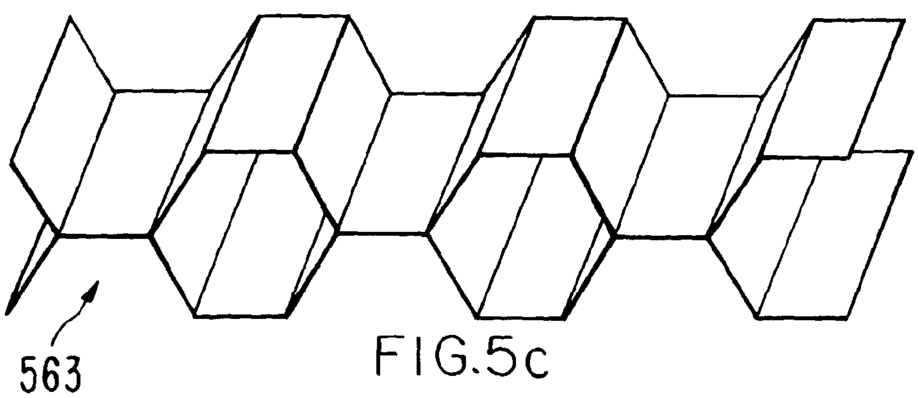


FIG. 5c

FIG.6a

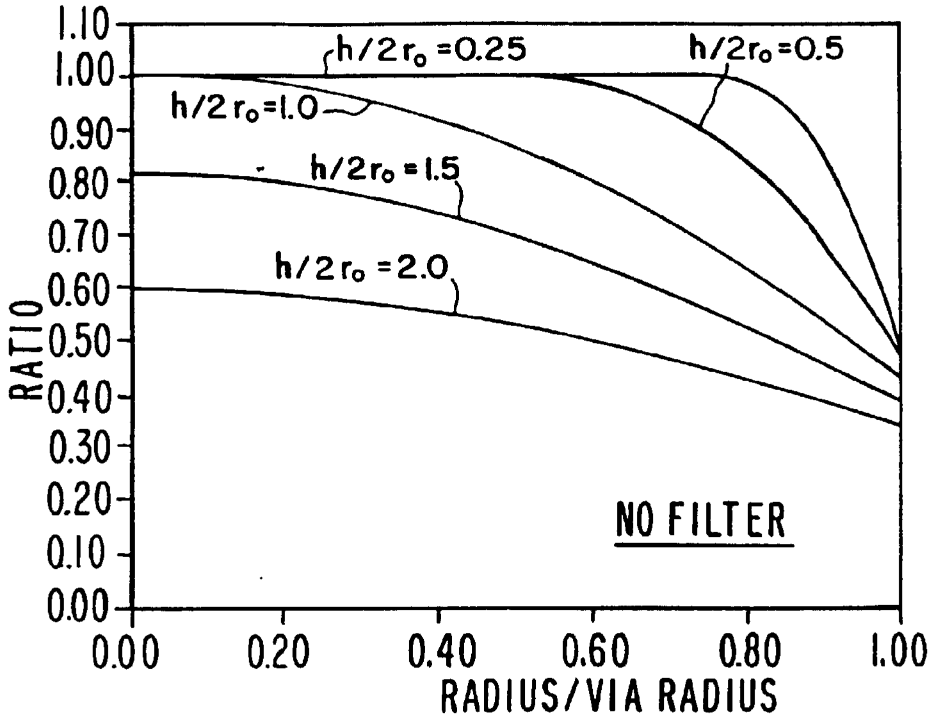
1.10
1.00
0.90
0.80
0.70
0.60
0.50
0.40
0.30
0.20
0.10
0.00
RATIO
h/2r₀ =0.25
h/2r₀=0.5
h/2r₀=1.0
h/2r₀=1.5
h/2r₀ =2.0
NO FILTER
0.00
0.20
0.40
0.60
0.80
1.00
RADIUS/VIA RADIUS

FIG.6b

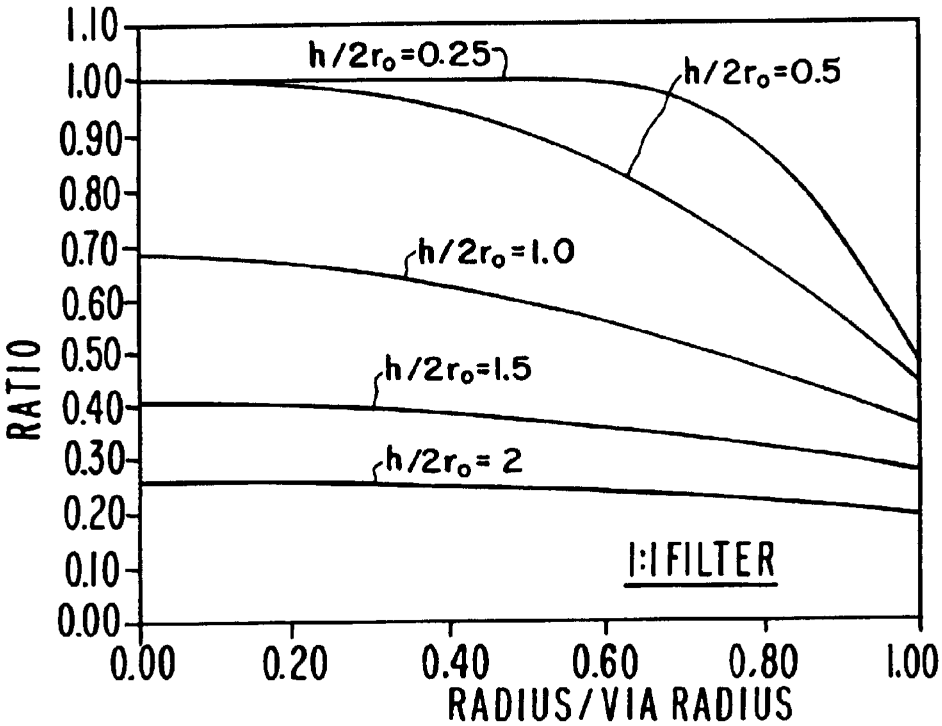
1.10
1.00
0.90
0.80
0.70
0.60
0.50
0.40
0.30
0.20
0.10
0.00
RATIO
h/2r₀=0.25
h/2r₀=0.5
h/2r₀=1.0
h/2r₀=1.5
h/2r₀= 2
1:1 FILTER
0.00
0.20
0.40
0.60
0.80
1.00
RADIUS/VIA RADIUS

FIG.6c

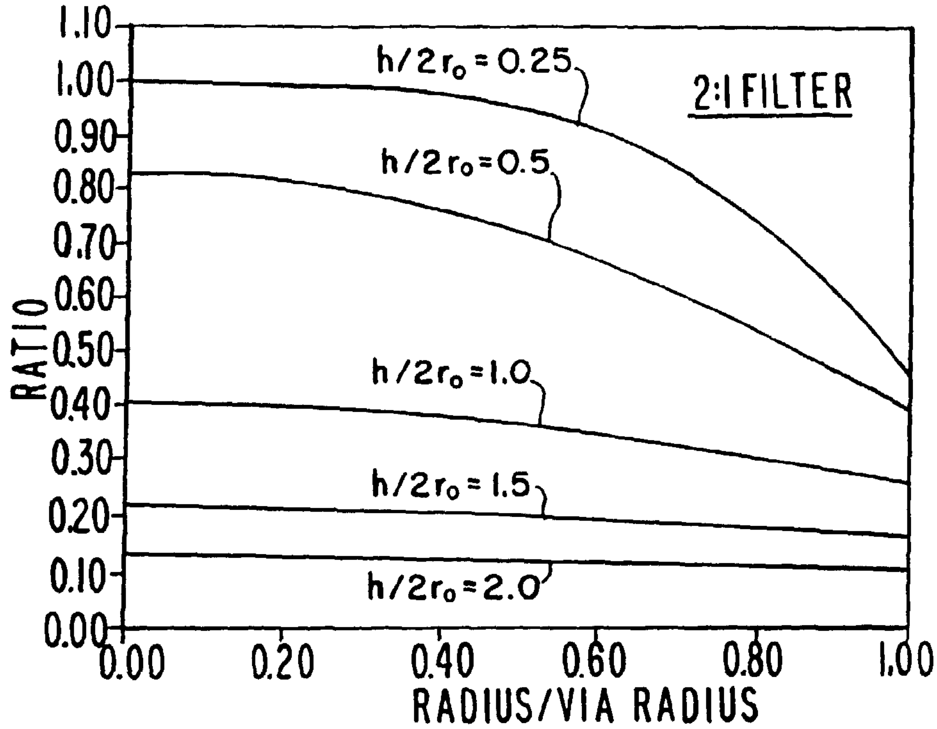
2:1 FILTER
RATIO
1.10
1.00
0.90
0.80
0.70
0.60
0.50
0.40
0.30
0.20
0.10
0.00
$h/2r_o = 0.25$
$h/2r_o = 0.5$
$h/2r_o = 1.0$
$h/2r_o = 1.5$
$h/2r_o = 2.0$
0.00
0.20
0.40
0.60
0.80
1.00
RADIUS/VIA RADIUS

FIG.6d

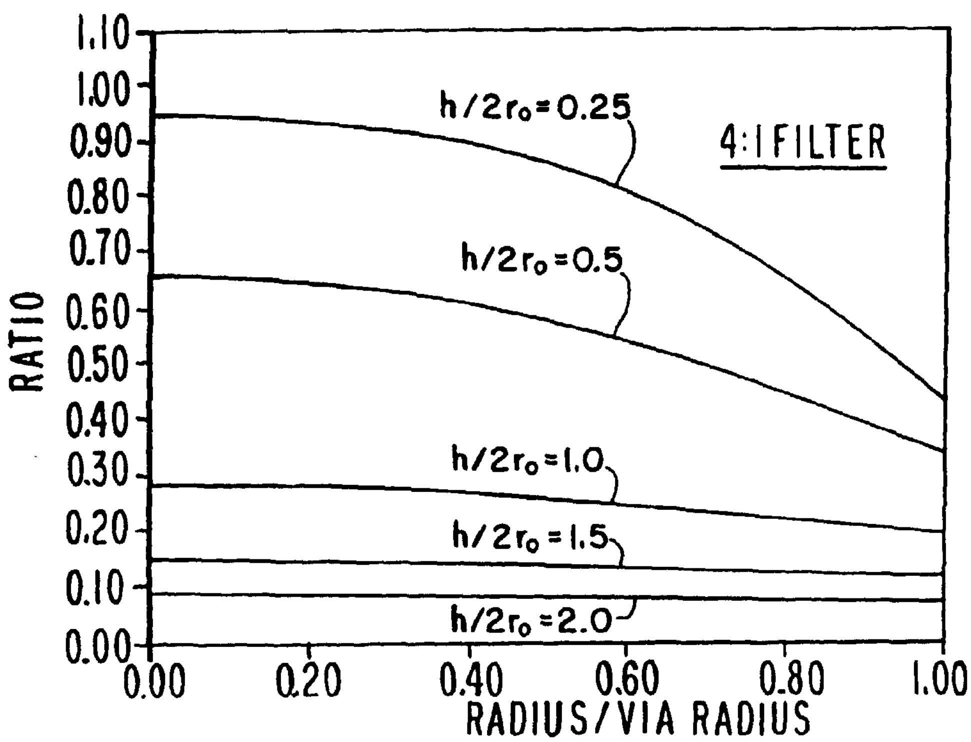
4:1 FILTER
RATIO
1.10
1.00
0.90
0.80
0.70
0.60
0.50
0.40
0.30
0.20
0.10
0.00
$h/2r_o = 0.25$
$h/2r_o = 0.5$
$h/2r_o = 1.0$
$h/2r_o = 1.5$
$h/2r_o = 2.0$
0.00
0.20
0.40
0.60
0.80
1.00
RADIUS/VIA RADIUS

FIG.7a

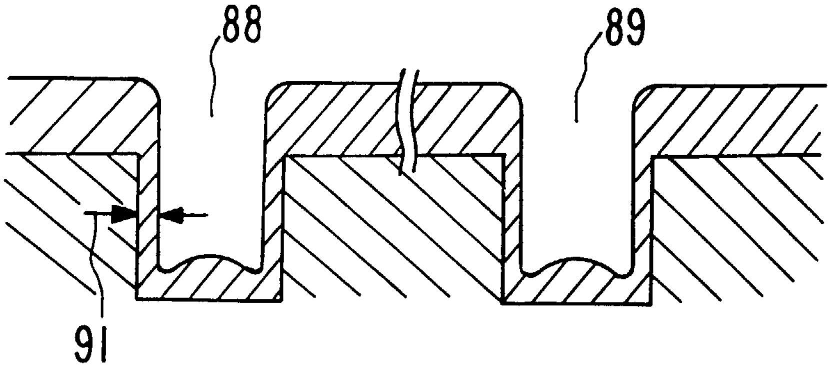


FIG.7b